# EUROPÄISCHE PATENTSCHRIFT

(11) **EP 1 421 429 B1**
(45) Veröffentlichungstag und Bekanntmachung des Hinweises auf die Patenterteilung: **24.01.2007**
(21) Anmeldenummer: 02742893.7
(22) Anmeldetag: 12.04.2002
(51) Int. Cl.: G02B 26/10

(54) **RESONANZSCANNER**
RESONANCE SCANNER
SCANNER A RESONANCE

(30) Priorität: 12.04.2001 DE 10119073
(43) Veröffentlichungstag der Anmeldung: 26.05.2004
(73) Patentinhaber: Jenoptik Ldt GmbH, 07548 Gera (DE)
(72) Erfinder: GESSNER, Thomas, 09113 Chemnitz (DE); DÖTZEL, Wolfram, 09127 Chemnitz (DE); KAUFMANN, Christian, 09217 Burgstädt (DE); MEHNER, Jan, 09221 Neukirchen (DE); Hahn, Ramon, 09126 Chemnitz (DE); KURT, Steffen, 09380 Thalheim (DE)
(74) Vertreter: Geyer, Fehners & Partner
(86) Internationale Anmeldenummer: PCT/EP2002/004118
(87) Internationale Veröffentlichungsnummer: WO 2002/099504

(56) Entgegenhaltungen:
- WO-A-98/44571
- DE-A- 4 334 267
- PATENT ABSTRACTS OF JAPAN vol. 1995, no. 07, 31. August 1995 (1995-08-31) -& JP 07 092409 A (CANON INC), 7. April 1995 (1995-04-07)

## Beschreibung

Die Erfindung bezieht sich auf einen Resonanzscanner, bei dem ein Aktorteil Befestigungselemente zum Verbinden mit einem. Statorteil, eine Antriebsplatte, einen Spiegel und Torsionsfedem aufweist, wobei die Antriebsplatte an den Befestigungselementen über zwei erste Torsionsfedern so befestigt ist, daß sie um eine gemeinsame erste Torsionsachse der ersten Torsionsfedern schwingungsfähig ist und eine erste Eigenfrequenz aufweist, der Spiegel innerhalb und an der Antriebsplatte durch zwei zweite Torsionsfedern so befestigt ist, daß er um eine gemeinsame zweite Torsionsachse der zweiten Torsionsfedern schwingungsfähig ist und eine zweite Eigenfrequenz aufweist, die sich von der ersten Eigenfrequenz unterscheidet die erste Torsionsachse und die zweite Torsionsachse parallel zueinander liegen und am Statorteil ein Antriebsmittel im Bereich der Ausdehnung der Antriebsplatte angeordnet ist, mittels dem Kraft unmittelbar auf die Antriebsplatte ausübbar ist, wobei das Antriebsmittel derart ansteuerbar ist, daß die Kraft einer periodischen Funktion folgt, deren Periode auf die zweite Eigenfrequenz abgestimmt ist wobei das Statorteil kastenförmig mit umlaufenden Seitenwänden und einem Boden ausgebildet ist, die Befestigungselemente als Rahmen ausgebildet sind, der an den Seitenwänden des Statorteils befestigt sind, die Antriebsmittel am Boden des Statorteils liegen und der Boden im Bereich des Spiegels eine Ausnehmung hat, die die Dämpfung des Spiegels reduziert und die mindestens so groß bemessen ist, daß eine maximale mechanische Auslenkung des Spiegels nicht durch den Boden begrenzt wird. Die Erfindung bezieht sich weiter auf ein Herstellverfahren für einen solchen Resonanzscanner, wie er aus der JP 07092409 bekannt ist.

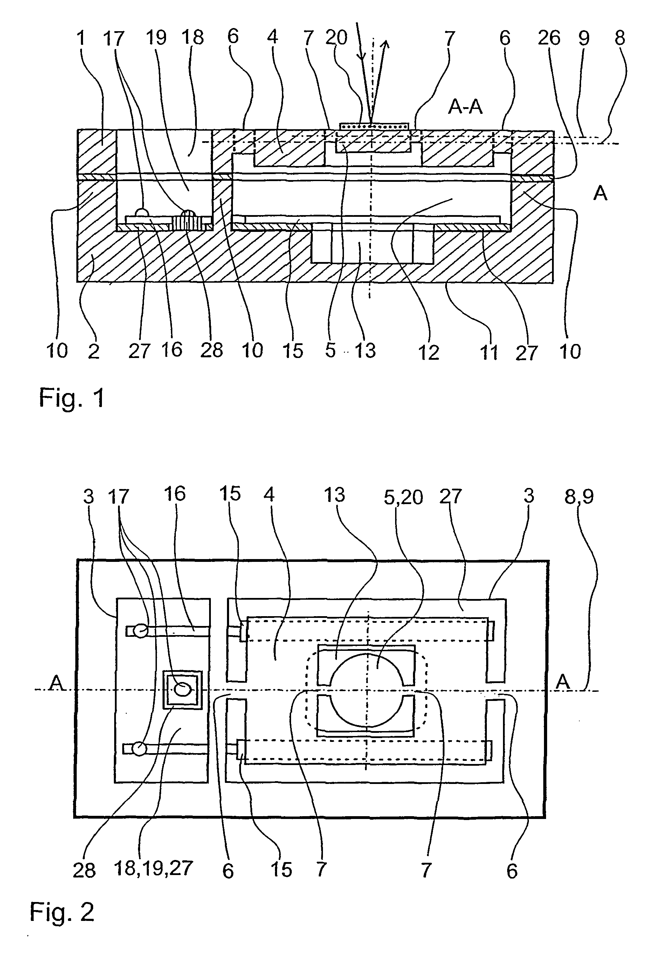

Die Grundprinzipien elektromechanischer Strahlablenksysteme sind in Stan Reich, "The use of etectro-mechanical mirror scanning devices", SPIE Vol. 84, Laser Scanning Components & Techniques (1976), Fig. 1, dargestellt. Im rechten Bildteil ist dort eine Gruppe von Scannern gezeigt, auf die sich die Erfindung bezieht, die sog. Resonanzscanner. Der Antrieb der Spiegelfläche erfolgt bei Resonanzscannem je nach Spiegelgröße und erforderlicher Dynamik durch elektromagnetische, elektrostatische oder piezoelektrische Antriebe.

Der elektrostatische Antrieb wird häufig verwendet. Die Vorteile dieses Prinzips bestehen darin, daß keine zusätzlichen Materialien, wie beispielsweise metallische Leitbahnen bzw. Magnete (wie für elektrodynamischen Antrieb) oder piezoelektrische Materialen (wie für piezoelektrischen Antrieb) auf dem Spiegel verwendet werden müssen, die sich negativ auf die Höhe der zu erreichenden Resonanzfrequenz, auf die Scanngeschwindigkeit und gegebenenfalls auf die Ebenheit der lichtreflektierenden Fläche auswirken.

Ein elektrostatischer Antrieb erfordert jedoch einen elektrischen Feldraum, der zur Erzielung hoher Feldstärken zwischen dem Spiegel und in geringem Abstand angebrachten Elektroden gebildet wird. Üblicherweise sind Elektroden feststehend, großflächig und parallel zur Ruhestellung des Spiegels konstruiert. Der Vorteil dieser Anordnung besteht darin, daß sich das Antriebsmoment auch bei ausgelenktem Spiegel nicht vermindert und der Scanner besonders effektiv bis zur Maximalauslenkung angetrieben werden kann. Wegen des erforderlichen kleinen Abstandes im Bereich bis ca. 500 µm wird der Auslenkwinkel solcher Scanner wesentlich durch den sich hierbei bildenden mechanischen Anschlag und durch Instabilitäten des elektrostatischen Antriebs (pull-in Effekt) begrenzt.

In der Literatur werden Lösungen beschrieben, die dieses Problem teilweise beheben. In K. Reimer, H.J, Quenzer, M. Jürss, B. Wagner, "Micro-optic fabrication using one-level gray-tone lithography", Miniaturized Systems with Micro-Optics and Micromechanics II, Proc. SPIE 3008, pp. 279 - 288, 1997, werden zum Spiegel geneigte Elektroden eingesetzt, die am Spiegelrand einen größeren Abstand besitzen und dadurch eine größere Auslenkung ermöglichen. Wegen der geringeren Feldstärke im Randbereich ist jedoch eine größere Ansteuerspannung erforderlich. Weitere Konstruktionen sind in H. Schenk, P. Dürr, H. Kück, "A novel electrostatically driven torsional actuator", Proc. of MOEMS '99 Conference, Mainz, Germany, und in R. A. Conant, J. T. Nee, K. Y. Lau, R. S. Muller, "A flat high-frequency scanning micromirror", IEEE Solid State Sensor and Actuator Workshop, Hilton Head, June 2000, pp. 6-9, beschrieben, wobei anstelle einer großflächigen Elektrode speziell ausgebildete Kammelektroden am Rand des Spiegels bzw. an zusätzlich angebrachten Antriebsstegen ein elektrostatisches Streufeld nutzen, um den Spiegel zur Schwingung anzuregen.

Bei diesen Lösungen begrenzen die oben genannten Effekte den maximal möglichen Auslenkwinkel nicht. Wegen der Nutzung des Streufeldes wirkt das elektrostatisch erzeugte Drehmoment jedoch nur in einem Bruchteil der Schwingbewegung besonders stark, und während des restlichen Bewegungszyklus arbeitet der Antrieb weniger effektiv.

Die DE 197 285 98 C2 schlägt eine diesbezüglich verbesserte Vorrichtung vor, bei der ein Torsions-Doppelpendel mit einem als ersten Torsionsschwinger ausgebildeten Antriebsteil und einem damit gekoppelten zweiten Torsions-Schwinger, der eine Spiegelfläche trägt, ausgebildet ist. Durch Antreiben des ersten Torsionsschwingers bei einer Frequenz, die der Resonanzfrequenz des gekoppelten, zweiten Torsionsschwingers entspricht, wird eine Resonanzüberhöhung des zweiten Torsionsschwingers und damit eine hohe Amplitude erreicht.

Ein ähnlicher Torsions-Doppelpendelaufbau ist in der DE 433 426 7 A1 offenbart, wobei der erste Torsionsschwinger eine rahmenförmige Antriebsplatte ist, in der als zweiter, gekoppelter Torsionsschwinger eine Spiegelfläche drehbar aufgehängt ist. Die rahmenförmige Antriebsplatte ist über plattenförmige Befestigungselemente an einem Grundträger angebracht.

In Buser R., "Theoretical and Experimental Investigations on Silicon Single Crystal Resonant Structures", Dissertation, University of Neuchatel, Switzerland, 1989, Seiten 165 - 179, sowie Buser R. und Rooij N., "Very High Q-Factor Resonators in Monocrystalline Silicon Sensors and Actuators, A21-A23, 1990, S. 323-327, sind verschiedene Strukturen beschrieben, die als Torsionsschwinger ausgebildet sind. Dort werden Torsions-Doppelpendel als Sensor (z.B. Drucksensor) verwendet, wobei ein innerer Schwinger mit Hilfe von Torsionsfedern an einem Rahmen und der Rahmen wiederum mit Hilfe von Torsionsfedern an einer den Rahmen umgebenden Einspannvorrichtung gelagert ist. Der innere Schwinger und der Rahmen sind dicht über einer Glasplatte angeordnet. Die auf der Glasplatte aufgebrachten Statorelektroden überdecken den Flächenbereich des inneren Schwingers weitreichend. Nur der Bereich neben den Torsionsfedern enthält keine Elektrodenbeschichtung. Bei der vorgesehenen Sensoranwendung wird die Amplitudenänderung des inneren Schwingers ausgewertet.

Der Erfindung liegt die Aufgabe zu Grunde, einen Resonanzscanner zu schaffen, der einfach aufgebaut und mit wenig Aufwand ansteuerbar ist. Dabei soll die schwingende Spiegelfläche bei großer reflektierender Fläche einen großen Ablenkwinkel auch bei hoher Ablenkfrequenz ermöglichen.

Die Lösung der Aufgabe gelingt erfindungsgemäß bei einem Resonanzscanner der eingangs genannten Art dadurch, daß die Ausnehmung sich entlang den Torsionsachsen mindestens so lang erstreckt, wie die Ausdehnung der danüberliegenden Antriebsplatte ist. Ein Herstellverfahren für einen Resonanzscanner sieht weiter vor, daß mehrere Aktorteile auf einem Aktorwafer und mehrere Statorteile auf einem Statorwafer strukturiert und konfektioniert werden, ein strukturierter Aktorwafer mit einem strukturierten Statorwafer einseitig oder ein strukturierter Aktorwafer mit zwei Statorwafern beidseitig durch ein mikromechanisches Fügeverfahren verbunden wird und dieser Verbund durch Trennschnitte in mehrere Resonatorscanner vereinzelt wird, wobei ein erfindungsgemäßer Resonanzscanner hergestellt wird.

Das schwingungsfähige System aus Spiegel und Antriebsplatte ist derart dimensioniert, daß es bei einer periodischen Funktion der Kraftwirkung mit einer Arbeitsfrequenz eine wesentliche und nutzbare Verstärkung einer Amplitude des Spiegels in bezug auf eine Amplitude der Antriebsplatte aufweist.

Die Arbeitsfrequenz f_{A} ist bei einer Amplitudenmodulation der Kraftwirkung konstant und liegt nahe der Resonanzfrequenz f_{R} des schwingungsfähigen mechanischen Systems des Spiegels. Für das Regelverhalten des Spiegels ist es günstig, wenn die Arbeitsfrequenz f_{A} nicht genau mit der Resonanzfrequenz f_{R} des Spiegels übereinstimmt. Bei einer hohen Dämpfung des mechanischen Schwingspiegels liegt die Arbeitsfrequenz f_{A} näher an der Resonanzfrequenz f_{R}, bei einer geringen Dämpfung weiter weg davon. Bei einer Frequenzmodulation der Kraftwirkung innerhalb eines Bereiches Δf_{A}wird die Amplitude der Kraftwirkung konstant gehalten.

Entspricht die Arbeitsfrequenz genau der Resonanzfrequenz des Spiegels, wird die größte Schwingamplitude des Spiegels erreicht. Liegt die Arbeitsfrequenz neben der Resonanzfrequenz, wird die Amplitude entsprechend kleiner. Das Modulationsverfahren und eine entsprechende Wahl der Arbeitsfrequenz erzeugen in Abhängigkeit von der vorliegenden konstruktiven Dimensionierung einen gewünschten Phasenwinkel der Scannbewegung und eine gewünschte Amplitude.

Der erfindungsgemäße Resonanzscanner besteht aus zwei gekoppelten Torsionsschwingem, wobei die Antriebsplatte und ihre unmittelbar angreifenden ersten Torsionsfedern einen äußeren Resonator und der Spiegel und seine unmittelbar angreifenden zweiten Torsionsfedern einen inneren Resonator bilden.

Dieses gekoppelte Schwingersystem weist zwei gleiche für die Funktion wichtige Rotationsfreiheitsgrade auf. Gleichzeitig existieren zwei Eigenfrequenzen und die dazugehörigen Eigenschwingformen. Für eine angestrebte große Auslenkung des Scanners wird diejenige Schwingform auf ihrer Resonanzfrequenz angeregt, deren Eigenvektoren ein hohes Amplitudenverhältnis des inneren Schwingers, des Spiegels, in bezug auf den äußeren Schwinger, die Antriebsplatte, aufweist. Die Erregung erfolgt nur am äußeren Schwinger, der Antriebsplatte. Die Antriebsplatte hat eine vergleichsweise große flächenhafte Ausdehnung. Somit werden einerseits größere Kraftwirkungen erzielt, andererseits ist deren Dämpfung größer.

Mit der Trennung des schwingungsfähigen Systems in die Antriebsplatte und den Spiegel kann eine Optimierung der Anordnung jedes dieser Bauteile innerhalb seiner Umgebung durchgeführt werden. Die Ausnehmung im Statorteil im Bereich des Spiegels ermöglicht seine große Schwingamplitude und reduziert seine Dämpfung.

Da bei einem Resonanzscanner die exakte Lage des Spiegels, d.h. des inneren Schwingers, eine für die optische Qualität ausschlaggebende Größe ist, muß der gesamte Aufbau möglichst verwindungssteif ausgeführt werden. Dies wird beim erfindungsgemäßen Resonanzscanner dadurch erreicht, daß das Statorteil kastenförmig mit umlaufenden Seitenwänden und einem Boden ausgebildet ist. Ein solcher kastenförmiger Aufbau weist eine hohe strukturelle Festigkeit auf und zeigt eine besonders geringe Verwindungsneigung bei den im Betrieb auftretenden Schwingungen.

Um einen möglichst festen bzw. steifen Resonanzscanner zu erhalten, der sich auch bei einem Betrieb des inneren Schwingers nahe oder bei der Resonanzfrequenz möglichst wenig verzieht und damit eine gute optische Qualität gewährleistet, ist es weiter vorgesehen, daß auf den umlaufenden Seitenwänden des kastenförmigen Statorteils ein Rahmen befestigt ist, an dem die Torsionsfedern mit der Antriebsplatte hängt. Durch den Rahmen, der auf umlaufenden Seitenwänden eines Statorteils befestigt ist, wird ein hochfester Resonanzscanner erreicht, der auch bei hohen Betriebsfrequenzen keine unerwünschten Verwindungen zeigt, wodurch die Schwingungsform des inneren Schwingers sehr genau vorhersagbar und damit steuerbar ist. Dadurch wird eine hohe optische Qualität des Scanners sichergestellt, wie sie beispielsweise für Projektionsanwendungen erforderlich ist. Das kastenförmige Statorteil in Kombination mit dem darauf befestigten Rahmen erlaubt es, hohe Antriebkräfte aufzubringen, ohne das über die anzuregende Torsionsschwingung eine Verformung des Stators oder des Aktors stattfindet. Zusätzlich garantiert der Rahmen, an dem die Torsionsfedern mit der Antriebsplatte hängen, daß zu allen Zeilen, also auch während der Montage, die Eigenspannung des Materials, insbesondere im Bereich der Torsionsfedern unverändert ist.

Der mögliche geringe Abstand der Antriebsplatte von dem Statorteil ermöglicht eine Optimierung des Antriebs mit dem Ziel, große Kräfte zu übertragen und kleine Winkelbewegungen zu erzeugen, die durch die mechanische Kopplung in eine große Auslenkung des Spiegels, bis in die Größenordnung +/-10°, übersetzt werden.

Zur Erzeugung der Antriebskräfte steht ein Antriebsmittel mit der Antriebsplatte in Wechselwirkung, oder die Antriebsplatte enthält selbst Teile des Antriebsmittels. Vorzugsweise wird die Antriebsplatte durch elektrostatische und/oder elektromagnetische Kräfte zur Bewegung angeregt. Es ist deshalb eine Weiterbildung bevorzugt, bei der das Antriebsmittel elektrostatische und/oder elektromagnetische Kräfte erzeugt, wobei auf dem Statorteil fest angeordnete Komponenten des Antriebsmittels mit auf einer dem Boden zugewandten Fläche der Antriebsplatte angeordneten Komponenten des Antriebsmittels oder der Antriebsplatte selbst zusammenwirken. Die Erfindung ist jedoch nicht auf diese Antriebskonzepte begrenzt, vielmehr sind weitere geeignete Antriebskonzepte und Alternativen aus der Literatur hinreichend bekannt.

Die auf die Antriebsplatte einwirkenden Kräfte werden zum Beispiel elektrostatisch, elektromagnetisch, pneumatisch oder piezoelektrisch erzeugt. Ein wesentlicher Vorteil des erfindungsgemäßen Resonanzscanners besteht darin, daß die Antriebsplatte beidseitig Flächen hat, an denen Antriebskräfte angreifen oder an der Antriebskräfte erzeugt werden können. Somit können ein Antriebssystem oder gleichzeitig zwei Antriebssysteme auf die Antriebsplatte einwirken. Dazu ist in einer Ausführungsform am Rahmen des Aktorteils beidseitig, gegenüberliegend jeweils ein Statorteil befestigt.

Besondere Vorteile liefert ein elektrostatischer Antrieb, da dieser mit einem vergleichsweise geringen Aufwand realisierbar und preiswert ansteuerbar ist. Bei einem elektrostatischen Antrieb läßt sich der Resonanzscanner ohne Probleme mit großflächigen gegenüberstehenden Elektroden realisieren. Eine schwingende Fläche der Antriebsplatte übernimmt die Funktion einer Elektrode, und dieser Fläche stehen weitere Elektroden gegenüber, die mit dem Statorteil verbunden sind.

Die Antriebsplatte stellt eine bewegliche Elektrode dar, im Boden des Statorteils ist eine gegenüberliegende Elektrode fest angeordnet. Der Spiegel wird durch die Antriebsplatte über die zweiten Torsionsfedern indirekt zur Schwingung in seiner oder nahe seiner Eigenfrequenz gebracht.

Am Spiegel selbst ist keine elektrostatische Feldwirkung erforderlich. Diese ist sogar völlig unerwünscht, so daß es zweckmäßig ist, daß nur auf der Antriebsplatte eine Gegenelektrode aufgebracht ist oder nur diese als solche wirkt. Dadurch kann man vorteilhafterweise den Abstand zwischen Spiegel und dem umgebenden Statorteil als Gehäuse so groß wählen, daß eine vergleichsweise große Winkelauslenkung des Spiegels realisierbar ist, deren Größe nicht durch einen mechanischen Anschlag begrenzt wird.

Zusätzlich führen die möglichen größeren Freiräume zwischen den Gehäuseteilen und dem Spiegel zu einer erheblich geringeren Dämpfung des Spiegels durch die umgebende Luft, welches unmittelbar Auswirkungen zur Größe der erzielbaren Resonanzüberhöhung hat. Mit der Verminderung der Luftdämpfung wird gleichzeitig ein größerer mechanischer Gütefaktor und dadurch eine vergrößerte Auslenkung erzielt.

Im Bereich der Antriebsplatte sind die zwei, vergleichsweise großflächig gestalteten, parallel zueinander stehenden Elektroden in besonders geringem Abstand zueinander (z.B. 30 µm) angeordnet. Aufgrund der Resonanzfrequenz des Spiegel/Feder-Systems wird die Antriebsplatte relativ zum Spiegel eine wesentlich kleinere Auslenkung erfahren, was die Minimierung des Elektrodenabstandes und infolgedessen einen proportional verminderten Ansteuerspannungsbedarf ermöglicht.

Der Aufbau des Resonanzscanners erfolgt besonders einfach, wenn das Aktorteil, bestehend aus dem Rahmen, der Antriebsplatte, dem Spiegel und den Torsionsfedern, in einem Stück aus einem torsionsbeständigen Federmaterial hergestellt ist. Bei einem Stahlwerkstoff wird das Aktorteil zweckmäßig durch Laser-Schneiden hergestellt. Besonders geeignet ist einkristallines Silizium, bei dem vorzugsweise lithographische Verfahren zur Strukturierung eingesetzt werden.

Einkristallines Silizium zeichnet sich dadurch aus, daß es bei Torsionsbeanspruchung keinerlei Ermüdungserscheinungen zeigt, und daß hochentwickelte technologische Verfahren zur Massenproduktion zur Verfügung stehen. Die Erfindung ist jedoch nicht auf die Verwendung eines Materials begrenzt. Vielmehr eignen sich zum Beispiel auch spezielle Stahlblechsorten, Spezialgläser oder Keramiken.

Der Spiegel weist vorzugsweise ein Material auf, das für die Wellenlänge, die reflektiert werden soll, ein gewünschtes hohes Reflexionsvermögen besitzt. Dazu ist es vorteilhaft, wenn eine Wirkfläche des Spiegels, mit einer reflektierenden Schicht oder einer reflektierenden Schichtfolge beschichtet ist.

Bei einem doppelt wirkenden Antriebssystem ist ein Elektrodensystem unterhalb der Antriebsplatte und ein Elektrodensystem oberhalb der Antriebsplatte angeordnet. Durch eine gegentaktige Ansteuerung wird entweder die Höhe der Ansteuerspannung weiter reduziert oder die Antriebskraft entsprechend erhöht.

Die räumliche Trennung von Spiegel und Antrieb hat auch den Vorteil, daß ein beidseitiger optischer Zugang zu den gegenüberliegenden Spiegelflächen geschaffen ist. Die Antriebsmittel sind so weit außerhalb des Spiegels angeordnet, daß dadurch für den optischen Strahlenverlauf praktisch keinerlei Einschränkungen entstehen.

Eine vorteilhafte Ausgestaltung des Resonanzscanners besteht diesbezüglich darin, daß sich zwei Wirkflächen des Spiegels, z.B. eine erste reflektierenden Fläche und eine zweite reflektierende Fläche, parallel gegenüberliegen, die jeweils bei zumindest einer Wellenlänge des elektromagnetischen Spektrums reflektieren. Diese Ausgestaltung des Spiegels ermöglicht es, daß die erste Fläche zur Reflexion eines Nutzstrahles und die zweite Fläche zur Reflexion eines Meßstrahles ausgelegt ist.

Dadurch kann man einen Nutzstrahl mit einer der Spiegelflächen ablenken und mit der gegenüberliegenden, rückseitigen Spiegelfläche die Spiegelposition optisch detektieren. Eine Messung der Spiegelstellung kann auch durch eine Kapazitätsmessung an der Antriebsplatte erfolgen, da eine Rückwirkung des schwingenden Spiegels auf die Antriebsplatte auswertbar ist.

Die Erfindung ist auch für die Fälle anwendbar, in denen das als Spiegel bezeichnete Bauteil für Wellenlängen des elektromagnetischen Spektrums durchlässig ist. Dann hat der Spiegel die Wirkung einer schwingenden Planparallelplatte oder einer schwingenden Linse, die zum Beispiel ebenfalls eine Strahlablenkung liefern.

Eine weitere Ausgestaltung des als Spiegels bezeichneten Bauteiles besteht darin, daß die erste Fläche und/oder die zweite Fläche des Spiegels eine Krümmung aufweist und somit eine strahlformende Wirkung hat/haben.

Eine weitere vorteilhafte Ausgestaltung besteht darin, daß die Ausnehmung des Statorteils im Bereich des Spiegels so ausgebildet ist, daß das Statorteil in diesem Bereich eine durchgehende Öffnung hat. Mit dieser Maßnahme ist die rückseitige Spiegelfläche nahezu ohne Einschränkungen für eine Strahlablenkung zugänglich. Strahlt auf den Spiegel Licht mit einer Wellenlänge ein, für die dieser durchlässig ist, wird die optische Apertur nicht durch das Statorteil begrenzt. Die mechanische Dämpfung des schwingenden Spiegels wird durch die freie Öffnung noch zusätzlich reduziert.

Wird das Aktorteil beidseitig von je einem Statorteil umgeben, ist es zweckmäßig, daß beide Statorteile mit einer Öffnung versehen sind.

Der Resonanzscanner ist weiterhin durch ein Verfahren zu seiner Herstellung gekennzeichnet, bei dem mehrere Aktorteile auf einem Aktorwafer, vorzugsweise aus einkristallinem Silizium, und mehrere Statorteile, auf einem Statorwafer, vorzugsweise aus einkristallinem Silizium, strukturiert und konfektioniert werden.

Dabei wird ein strukturierter Aktorwafer mit einem strukturierten Statorwafer durch ein mikromechanisches Fügeverfahren verbunden. Derartige Verfahren sind zum Beispiel Kleben, Löten, Anglasen oder Wafer-Bonden, insbesondere Niedertemperatur-Silizium-Direktbonden, anodisches oder eutektisches Bonden. Der Verbund wird durch Trennschnitte in Resonanzscanner vereinzelt.

Werden an einem Aktorteil zwei Statorteile angeordnet, so wird ein strukturierter Aktorwafer auf jeder seiner zwei strukturierten Flächen mit jeweils einem Statorwafer verbunden.

Der Aktorwafer und der Statorwafer können besonders kostengünstig durch eine Kombination von Naß- und Trockenätzschritten aus dem Wafermaterial herausgebildet werden.

Die Strukturierung des Wafermaterials, die Konfektionierung mit Elektroden, elektrischen Leitern, Sensoren sowie Steuer- und Meßelektronik erfolgt mit den aus der Elektroniktechnologie bekannten Verfahren. Mit den bei zur Verfügung stehenden Technologien ist eine kostengünstige Massenfertigung realisierbar.

Die Resonanzscanner sind typisch mit einer Resonanzfrequenz oberhalb 20 kHz mit einem Spiegeldurchmesser im Bereich von 0,5 bis 5 mm für mechanische Ablenkwinkel im Bereich zwischen +/- 1 ° und +/-10° herstellbar.

Bei einer Arbeitsfrequenz von 24 kHz wird beispielhaft bei einem Spiegeldurchmesser von 2 mm ein mechanischer Ablenkwinkel von +/- 6° erzeugt.

Zum Erreichen hoher Antriebsfrequenzen kann es, je nach Ausgestaltung des Antriebsmittels, wünschenswert sein, die Kapazität der Antriebseinrichtung so gering wie möglich zu halten. In einem solchen Fall sind parasitäre Kapazitäten störend, die zwischen einem Antriebsmittel, das auf dem Boden des Statorteils angeordnet ist, und leitfähigen Bestandteilen des Statorteils selbst gebildet sind. Solche parasitären Kapazitäten treten bspw. auf, wenn eine Elektrode auf einem mit einer Isolationsschicht versehenen aber per se nicht isolierenden Silizium-Wafer angebracht sind. Dabei kann die elektrische Kapazität, die zwischen Statorelektrode und Silizium Grundkörper gebildet ist, sogar größer sein als die elektrische Kapazität zwischen Elektrode und Antriebsplatte. Die Ansteuerung ist dann äußerst schwierig; die elektrische Spannung einer Spannungsquelle zur Ansteuerung des Resonanzscanners liegt dann relativ hoch.

Aus diesem Zweck ist es zu bevorzugen, das Statorteil aus einem Grundmaterial mit hohem elektrischen Widerstand aufzubauen, da dann parasitäre Kapazitäten gering sind, insbesondere geringer als die Kapazität zwischen einer Statorelektrode und der Antriebsplatte. Dafür ist es zweckmäßig, daß das Statorteil einen Grundkörper aus einem elektrisch isolierenden Material, insbesondere Glas, Keramik oder Quarz, aufweist. Mit einem solchen Grundkörper wird, insbesondere beim elektrostatischen Antrieb, die elektrische Kapazität im wesentlichen durch die Antriebsplatte und die am Boden liegenden Antriebsmitteln bestimmt.

Man kann dann die Schwingung der Antriebsplatte und damit die Lage des Spiegels mittels kapazitiver Verfahren dedektieren, ohne daß zusätzliche Sensorik nötig wäre. Bei parasitären Kapazitäten, die in der Größenordnung der Kapazität zwischen Antriebsmittel und Antriebsplatte lägen, ist eine solche Messung zu stark gestört.

Für einen einfachen Einsatz eines Resonanzscanners ist ein Betrieb bei Umgebungsbedingungen anzustreben. Insbesondere sollte der Frequenzgang des Resonanzscanners so wenig wie möglich vom Luftdruck abhängen. Ein Druckgehäuse zum Absenken des Druckes würde zusätzliche Durchtrittsfenster für die abzulenkenden Strahlung nötig machen; diese brächten störende Abschwächungen und Reflektionen mit sich. Im übrigen wäre auch die Baugröße eines Resonatorscanners stark vergrößert.

Der Raum zwischen Boden des Statorteils und Unterseite der Antriebsplatte bzw. des Spiegels wird also bei normalen Anwendungen regelmäßig mit Luft bei Umgebungsdruck gefüllt sein. Dieser Bereich bildet also eine Luftfeder, die sich dämpfend auf die Bewegung der Antriebsplatte und des als inneren Schwinger ausgebildeten Spiegels auswirkt. Um diese Luftfeder so weit wie möglich auszuschalten, sieht die Erfindung eine Ausnehmung im Bereich des Bodens des Spiegels vor, die die Dämpfung der Spiegelbewegung reduziert. Die Luftfeder ist besonders reduziert, wenn die Ausnehmung als Öffnung im Boden ausgebildet ist. Neben der dadurch deutlich verminderten Dämpfung hat die Ausnehmung weiter noch den Vorteil, daß ein Anschlagen des Spiegels während der Drehschwingbewegung am Boden nicht möglich ist, da die Ausnehmung so groß bemessen ist, daß eine maximale mechanische Auslenkung des Spiegels nicht mehr durch den Boden begrenzt wird. Bei seiner Drehschwingbewegung kann sich der Spiegel in die Ausnehmung eindrehen.

Durch dieses Konzept kann der Abstand zwischen Antriebsplatte und Boden weiterhin sehr gering gehalten werden, ohne daß die Amplitude oder Frequenz der vom Spiegel auszuführenden Drehschwingung durch einen Anschlag am Boden oder durch eine Luftfederwirkung begrenzt wäre.

Unter dem Gesichtspunkt, am Boden keinen mechanischen Anschlag zu schaffen, genügt es, wenn die Ausnehmung bzw. Öffnung so gestaltet ist, daß die von den Spiegelrändern ausführbare Bewegungskurve nicht an einer Stelle am Boden endet. Es muß also theoretisch möglich sein, den Spiegel um 360° zu drehen, ohne das eine Berührung mit dem Boden stattfindet.

Unter dem Gesichtspunkt der Reduzierung einer Luftfederwirkung sollte die Ausnehmung noch über diesem Mindestmaß liegen. Es ist deshalb zu bevorzugen, daß die Ausnehmung größer ist, als die Projektion des darüberliegenden Spiegels auf die Ebene des Bodens, wenn sich der Spiegel in Ruhestellung befindet. Dadurch ist eine Luftfederwirkung minimiert. Eine derart gestaltete Ausnehmung ermöglicht ein optimales Verhältnis von Antriebsmoment und Dämpfung der Antriebsplatte einerseits und einem möglichst geringe Dämpfung des Spiegels andererseits, ohne das die mechanische Auslenkung des Spiegels durch den Boden begrenzt wäre.

Die Vergrößerung der Ausnehmung, die als Öffnung ausgeführt werden kann, reduziert allerdings auch die Fläche, die für das Anbringen des Antriebsmittels verfügbar ist, bspw. die maximale Fläche, die Statorelektroden haben können. Da das Antriebsmoment aber unterproportional mit der Verringerung der Antriebsfläche abnimmt, die Dämpfung jedoch, insbesondere bei den anzustrebenden hohen Frequenzen, überproportional mit der Vergrößerung der Ausnehmung bzw. Öffnung sinkt, wird durch eine vergrößerte Ausnehmung dennoch eine Verbesserung erreicht. Es ist deshalb zu bevorzugen, die Ausnehmung nicht nur in Querrichtung zu den Torsionsachsen so groß wie möglich zu halten, was unter dem Gesichtspunkt der verringerten Dämpfung und der Vermeidung eines mechanischen Anschlages wünschenswert ist, sondern sie auch parallel zu den Torsionsachsen so groß wie möglich zu halten. Erfindungsgëmaß ist deshalb eine Ausnehmung vorgesehen, die sich entlang der Torsionsachse mindestens so lang erstreckt, wie die Ausdehnung der Antriebsplatte ist. Durch eine derartige Ausnehmung wird nicht nur die Dämpfung des Spiegels vermindert, sondern auch noch vorteilhafterweise die Dämpfung der Antriebsplatte. Somit ist der mögliche Frequenzbereich auch diesbezüglich nach oben erweitert.

Kommen Antriebsplatte und Antriebsmittel in zu engen Kontakt, können je nach Ausbildung des Antriebsmittels Schäden auftreten. So haben bspw. bei elektrostatischen Antrieben Spannungsüberschläge eine Zerstörung oder eine Beschädigung der Elektroden zur Folge. Auch kann ein Anhaften der Antriebsplatte an der Elektrode auftreten, das, auch wenn es mitunter nur kurze Zeit anhält das gewünschte Schwingungsverhalten der Antriebsplatte und damit auch des Spiegels störend verändert. Da man andererseits für hohe Antriebsfrequenzen mitunter eine relativ starke Ansteuerung des Antriebsmittels bspw. hohe Steuerspannungen an einer Statorelektrode benötigt, sieht die Erfindung vorteilhafterweise vor, die Antriebsmittel so auszubilden, daß kein Kontakt zwischen Antriebsplatte und Antriebsmittel auftreten kann. Dazu können geeignete Anschläge vorgesehen werden, die verhindern, daß die Antriebsplatte an das Antriebsmittel anstoßen kann. Im Falle sehr flach bauender Antriebsmittel, bspw. bei Statorelektroden, ist es möglich, den Boden des Statorteils selbst als Anschlag zu nutzen, indem die am Boden liegenden Antriebsmittel so ausgebildet sind, daß auch bei voll ausgelenkter und am Boden anliegender Antriebsplatte immer noch ein Abstand bzw. Spalt zwischen Antriebsmittel und Antriebsplatte besteht. Das Antriebsmittel kann dabei bspw. in Richtung auf die Torsionsachse hin gerückt werden, so daß der Spalt auch dann besteht, wenn die Außenkante der Antriebsplatte, d.h. diejenige Kante, die der Torsionsachse am fernsten liegt und die größte Schwingungsamplitude ausführt, am Boden anliegt. Auch kann eine Aussparung im Antriebsmittel vorgesehen werden. Letzteres hat den Vorteil, daß die Verringerung der Fläche der Antriebsmittel so klein wie möglich ausfällt.

Die Elektroden auf dem Statorteil sind vorzugsweise nur in einem Bereich der Antriebsplatte ausgebildet, der einerseits durch die Ausnehmung im Boden des Statorteils begrenzt ist und andererseits einen Bereich, in dem die Antriebsplatte bei maximaler Auslenkung am Boden anschlagen kann, nicht umfaßt. Es ist somit in jedem Fall ein einen Abstand gewährleistender Spalt zwischen der Unterseite der Antriebsplatte und den Elektroden gewährleistet. Auch beim Anlegen hoher Spannungen kann dann kein Durchschlag zwischen Statorelektroden und Antriebsplatte bzw. Befestigungsrahmen oder Spiegel auftreten. Dadurch wird ein sicherer Betrieb bei hohen Antriebsspannungen erreicht.

Die Außenkanten der Statorelektroden, d.h. diejenigen Kanten, die von der Torsionsachse am weitesten entfernt sind, befinden sich somit immer genügend weit von den Außenkanten der Antriebsplatte und den Innenkanten des Befestigungsrahmens beabstandet, so daß der elektrischen Feldstärkespitzen an diesen Orten gemindert sind. Weiter wird ein thermisches Verbinden von Statorelektroden und Antriebsplatte bei Überlastung unmöglich, da diese gar nicht in Kontakt treten können.

Die Erfindung soll an Hand mehrerer Beispiele für einen Resonanzscanner beschrieben werden, der mit Hilfe von Verfahren der Halbleitertechnologie hergestellt wird. Die nachfolgend beschriebenen Figuren sind nicht maßstabsgerecht gezeichnet. Die geometrischen Abmessungen liegen in der Querschnittsdimension im Mikrometerbereich. Die Größe des Resonanzscanners liegt im Zentimeterbereich, die Größe des Spiegels selbst liegt typisch im Millimeterbereich. In den Zeichnungen zeigen:
- Fig. 1: eine Schnittdarstellung eines Resonanzscanners mit kaskadiertem elektrostatischen Antrieb mit einer Aussparung im Bereich des Spiegels,
- Fig. 2: eine Draufsicht auf den Resonanzscanners der Fig. 1,
- Fig. 3: eine Schnittdarstellung eines Resonanzscanners mit beidseitigem elektrostatischen Antrieb,
- Fig. 4: eine Schnittdarstellung eines Aktorteils für den Resonanzscanner der Fig. 3,
- Fig. 5: eine Draufsicht auf das Aktorteil der Fig. 4
- Fig. 6: eine Schnittdarstellung eines Statorteils für den Resonanzscanner der Fig. 3,
- Fig. 7: eine Draufsicht auf das Statorteil der Fig. 6,
- Fig. 8: eine Schnittdarstellung eines Resonanzscanners mit kaskadiertem elektromagnetischen Antrieb und mit einer Öffnung im Bereich einer schwingenden Planparallelplatte,
- Fig. 9: einer gegenüber dem Resonanzscanner der Fig. 1 abgewandelten Bauweise,
- Fig. 10: eine Darstellung ähnlich der Fig. 2 einer abgewandelten Bauweise,
- Fig. 11: eine Darstellung ähnlich der Fig. 3 einer abgewandelten Bauweise eines Resonatorscanners,
- Fig. 12: eine Darstellung ähnlich der Fig. 6 einer abgewandelten Bauweise,
- Fig. 13: eine Darstellung ähnlich der Fig. 7 einer abgewandelten Bauweise,
- Fig. 14 bis Fig. 17: Draufsichten auf einen Aktor- und Statorwafer bei der Herstellung eines Resonanzscanners.

Ein Resonanzscanner mit kaskadiertem Antrieb entsprechend den Darstellungen in den Fig. 1 und Fig. 2 besteht aus zwei mit Schichten versehenen Teilen, einem Aktorteil 1 und einem Statorteil 2, die jeweils aus einkristallinem Silizium gefestigt sind. Optional kann das Statorteil auch aus Glas, Quarz oder Keramik hergestellt werden. Aktorteil 1 und Statorteil 2 enthalten alle Elemente des mikromechanischen Resonanzscanners mit kaskadiertem Antrieb einerseits in Form der mechanischen Bestandteile Antriebsplatte 4, Spiegel 5 mit ersten und zweiten Torsionsfedern 6, 7, und andererseits in Form eines Antriebsmittels, im Beispiel bestehend aus Statorelektroden 15, Zuleitungen 16 und Bondinseln 17. Der hier beispielhaft beschriebene elektrostatisch angetriebene Resonanzscanner hat den Vorteil großflächiger paralleler Statorelektroden 15, bei gleichzeitig fehlendem mechanischen Anschlag des Spiegels 5.

Das Aktorteil 1 ist Teil einer strukturierten 300 µm dicken Siliziumscheibe. Es hat zweckmäßigerweise eine rechteckige Grundfläche, wie in der Draufsicht der Fig. 2 gezeigt ist. Diese Grundfläche ist so strukturiert, daß ein innerer Rahmen 3 eine Durchführung 18 umgrenzt sowie als Halterung für das schwingungsfähige System, bestehend aus den ersten Torsionsfedern 6, der Antriebsplatte 4, den zweiten Torsionsfedern 7 und dem Spiegel 5, dient.

Die ersten Torsionsbänder 6 verbinden die Antriebsplatte 4 mit dem Rahmen 3 des Aktorteils 1. Die Antriebsplatte 4 ist dadurch im Rahmen 3 aufgehängt. Die Torsionsbänder 7 verbinden den Spiegel 5 mit der Antriebsplatte 4.

Die ersten Torsionsbänder 6 legen eine erste Torsionsachse 8 und die zweiten Torsionsbänder 7 legen eine zweite Torsionsachse 9 fest. Es entstehen somit zwei an sich unabhängig voneinander schwingungsfähige Teile: die Antriebsplatte 4 und der Spiegel 5.

Wesentlich ist, daß die erste Torsionsachse 8 und die zweite Torsionsachse 9 parallel zueinander ausgerichtet sind. Durch diese Maßnahme entsteht ein stark gekoppeltes schwingungsfähiges System, mit den schwingenden Teilen Antriebsplatte 4 und Spiegel 5. Je besser die beiden Torsionsachsen 8, 9 übereinstimmen, je größer ist der Grad der Kopplung.

In der Fig. 1 ist der Querschnitt des Resonanzscanners der Fig. 2 dargestellt. Das Aktorteil 1 ist in diesem Beispiel so strukturiert, daß die Antriebsplatte 4, die ersten Torsionsfedern 6, die zweiten Torsionsfedern 7 und den Spiegel 5 jeweils eine unterschiedliche Dicke haben. Infolgedessen sind die erste Torsionsachse 8 und die zweite Torsionsachse 9 parallel zueinander versetzt. Die gewünschten bewegungsdynamischen Eigenschaften der schwingenden Teile des Aktorteils 1 werden im Beispiel mit einer Dimensionierung der Dicke jedes der Teile erreicht. Der Spiegel 5 ist 100 µm dick, die Antriebsplatte 4 ist 250 µm dick. In diesem Beispiel haben die zweiten Torsionsfedern 7 eine Dicke von 50 µm und die ersten Torsionsfedern 6 sind 70 µm dick.

Das Statorteil 2 ist Teil einer strukturierten 525 µm dicken Silizium- oder Glasscheibe mit einer nicht strukturierten Unterseite. In seinen Außenabmessungen ist das Statorteil 2 identisch mit dem Aktorteil 1. Seine inneren Abmessungen entsprechen denen des inneren Rahmens 3 des Aktorteils 1.

Das Statorteil 2 hat eine Grube 19, deren Lage und Abmessung mit der Durchführung 18 des Aktorteils 1 übereinstimmen. Die Grube 19 dient zur Aufnahme von Bondinseln 17 für die Stromzuführungen des Antriebsmittels und für Anschlüsse an Meß- und Steuerungsmittel, die nicht dargestellt sind.

Die Durchführung 18 im Aktorteil 1 gewährleistet für ein Bondwerkzeug den Zugang zur Herstellung der elektrischen Verbindungen.

Weiter ist im Statorteil 2 ein Freiraum 12 für den Platzbedarf des Antriebsmittels vorgesehen. Der Freiraum 12 ist so groß bemessen, daß er mit der inneren Begrenzung des Rahmens 3 des Aktorteils 1 übereinstimmt. Die durch den Freiraum 12 und die Grube 19 gebildeten Seitenwände 10 des Statorteils 2 dienen der Befestigung des Rahmens 3 des Aktorteils 1 mit Hilfe einer Bondschicht 26. Durch die Befestigung des Rahmens 3 mit den Seitenwänden 10 wird eine stabile Einheit erreicht.

Das Antriebsmittel ist im Beispiel ein elektrostatischer Antrieb, bestehend aus den zwei gegenphasig angesteuerten Statorelektroden 15 und einer Gegenelektrode, die im Beispiel durch das leitfähige Material der Antriebsplatte 4 selbst gebildet wird. Ein Polanschluß 21 stellt den elektrischen Kontakt her. In dem Freiraum 12 sind bodenseitig die zwei Statorelektroden 15 auf einer Isolatorschicht 27 isoliert zueinander parallel liegend, nebeneinander angeordnet und Ober die Zuleitungen 16 mit der jeweils einer Bondinsel 17 verbunden. Bei einem isolierenden Grundkörper des Statorteils kann die Isolatorschicht auch als Passivierungsschicht ausgeführt werden oder sogar ganz entfallen.

Die beiden Statorelektroden 15 sind flächenmäßig so weit ausgedehnt, wie sie von der Antriebsplatte 4 überdeckt werden. Insbesondere ist der Bereich unterhalb des Spiegels 5 nicht mit den Statorelektroden 15 versehen, ebenso ein diesen umgebender Rand sowie ein Gebiet unterhalb der Torsionsachsen 8, 9.

Weiter weist der Freiraum 12 im Bereich der flächenhaften Ausdehnung des Spiegels 5, dort wo keine Statorelektroden 15 aufgebracht sind, eine Ausnehmung 13 auf, die den Freiraum 12 in diesem Bereich wesentlich vergrößert.

Die Ausnehmung 13 ist ein wesentliches Merkmal der Erfindung. Allein dadurch wird die gewünschte vergleichsweise große Schwingungsamplitude des Spiegels 5 ermöglicht. Eine Luftfederwirkung kann, durch die Möglichkeit größere Körperabstände zu realisieren, wesentlich verringert werden, was die dynamischen Eigenschaften des schwingenden Spiegels 5 wesentlich verbessert. In den Fig. 1-3 und 6-8 entspricht die Größe der Ausnehmung längs den Torsionsachsen nicht der Erfindung gemäß den Ansprüchen.

Auf dem Spiegel, 5 ist auf der dem Boden 11 gegenüberliegenden Fläche eine Spiegelschicht 20 aufgebracht.

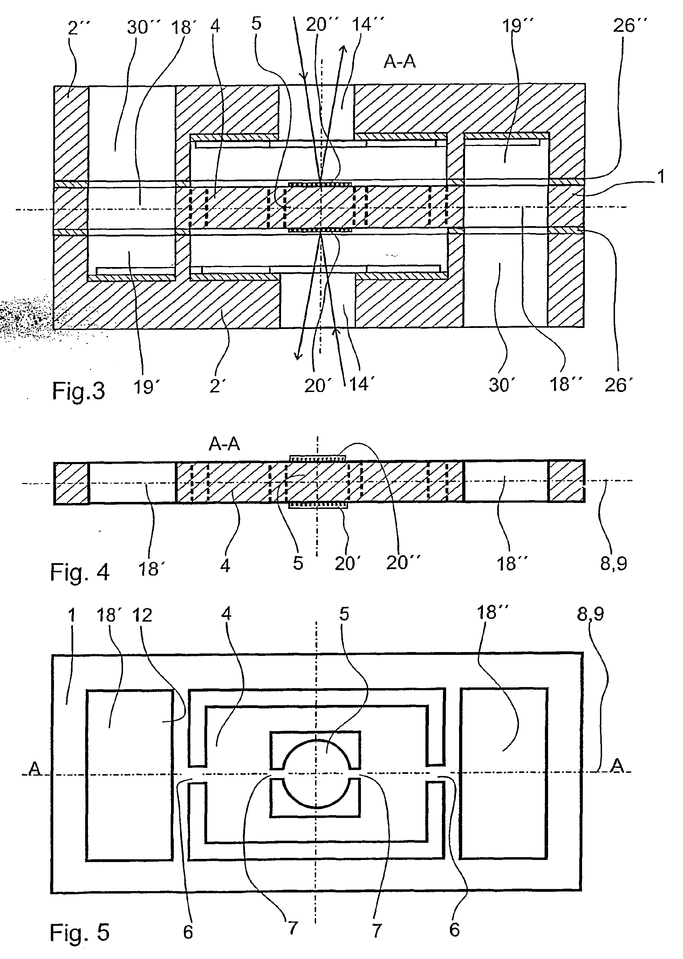

Fig. 3 zeigt einen Querschnitt des Resonanzscanners mit beidseitigem Antrieb. Ein Aktorteil 1 ist hier mit zwei Statorteilen, einem unteren Statorteil 2' und einem oberen Statorteil 2" verbunden. An beiden Flächen der Antriebsplatte 4 greifen elektrische Antriebskräfte an.

Das hier verwendete Aktorteil 1 in Fig. 4 im Querschnitt und in Fig. 5 in der Draufsicht gezeigt. Es entspricht im Prinzip dem Aktorteil 1 mit Durchführung 18', wie es in der Draufsicht der Fig. 2 gezeigt ist, mit dem Unterschied, daß in Fig. 3 eine weitere Durchführung 18" vorgesehen ist, die am rechten Bildrand gezeigt ist. Ein weiterer Unterschied besteht darin, daß das Aktorteil 1 im Beispiel der Fig. 3 und der Fig. 4 eine gleichmäßige Dicke von 200 µm aufweist. Die erste Torsionsachse 8 ist mit der zweiten Torsionsachse 9 identisch. Diese Maßnahme verbessert die Stabilität des gekoppelten schwingungsfähigen Systems. Durch eine Optimierung der geometrischen Abmessungen des Aktorteils 1 kann auf die Strukturierung des Querschnittes (wie in Fig. 1 gezeigt) verzichtet werden, was den Herstellungsaufwand drastisch reduziert. Weiter weist der Spiegel 5 in der Fig. 3 und der Fig. 4 beidseitig aufgebrachte Spiegelschichten 20' und 20" auf.

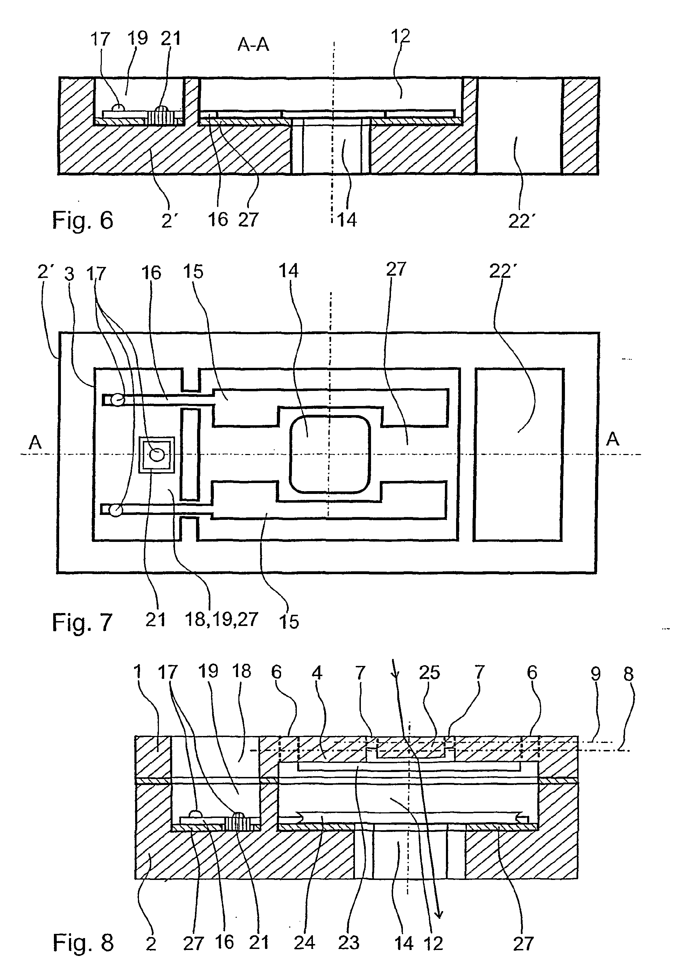

Fig. 6 zeigt den Querschnitt eines der Statorteile, hier das untere Statorteil 2', für einen Resonanzscanner gemäß Fig. 3. In Fig. 7 ist eine Draufsicht gezeigt. Das untere Statorteil 2' entspricht dem Aufbau, wie er zu Fig. 1 und zu Fig. 2 beschrieben wurde. Der Unterschied besteht darin, daß eine am rechten Bildrand gezeichnete Bondöffnung 30 vorgesehen ist.

Weiter ist im Unterschied zu Fig. 1 die Ausnehmung 13 im Beispiel der Fig. 3 im unteren Statorteil 2' als Öffnung 14' ausgebildet. Das obere Statorteil 2" hat eine gleiche Öffnung 14". Die Öffnungen 14' und 14" gewährleisten den ungehinderten Zugang optischer Strahlung auf jede der Spiegelschichten 20' und 20". Jeder Spiegelfläche 20' und 20" wird zur Reflexion eines Lichtbündels verwendet, zum Beispiel für ein Nutzlichtbündel und für ein Meßlichtbündel. Zusätzlich realisieren diese Öffnungen 14' und 14" die freie ungehinderte Bewegung des Spiegels 5 sowie die Verminderung der Luftdämpfung.

Bei einem achsensymmetrischen Aufbau des Resonanzscanners ist das obere Statorteil 2" genauso aufgebaut wie das untere Statorteil 2'. Diese Maßnahme senkt den Herstellungsaufwand. Das Aktorteil 1 wird zunächst mit dem unteren Statorteil 2' über die Bondschicht 26' verbunden. Dieser Verbund wird mit der dann noch frei liegenden Seite des Aktorteils 1 mit dem oberen Statorteil 2" über die Bondschicht 26" verbunden. Oberes Statorteil 2" und unteres Statorteil 2' sind identisch und werden zueinander seitenverkehrt auf dem Aktorteil 1 montiert. In Fig. 3 ist ersichtlich, daß jeweils zwei Statorelektroden 15' und 15" jeweils einer Fläche der Antriebsplatte 4 gegenüber stehen.

Die Durchführung 18' des Aktorteils 1 ist deckungsgleich mit der Bondöffnung 22" des oberen Statorteils 2" und die Durchführung 18" des Aktorteils 1 ist deckungsgleich mit der Bondöffnung 22' des unteren Statorteils 2'. Die Bondöffnung 22' und 22" in jeweils einem der Statorteile 2' und 2" sowie die Durchführungen 18' und 18" in dem Aktorteil 1 gewährleisten den Zugang der Bondwerkzeuge zum Herstellen der elektrischen Verbindungen.

Fig. 8 zeigt den Querschnitt eines Resonanzscanners, der in Analogie zu den in den Figuren 1 bis 7 beschriebenen aufgebaut sein kann, mit dem Unterschied, daß hier das Antriebsmittel als ein elektromagnetischer Antrieb realisiert ist. Das Aktorteil 1 trägt auf seiner dem Statorteil 2 zugewandten Seite eine hart-permanentmagnetische Schicht 23. Im Statorteil 2 sind im Bereich des Freiraums 12 auf der Isolatorschicht 27 zwei elektrische Stromkreise vorgesehen, deren nur schematisch dargestellte Spule 24 eine Flächenspule ist, die wechselnde elektromagnetische Kräfte erzeugt. Die Stromkreise zweier Flächenspulen sind in einem Abstand zueinander und symmetrisch beidseitig zu den Torsionsachsen 8, 9, in Analogie zu den Statorelektroden 15 der Fig. 2 oder 7, angeordnet. Die Kontaktierung der Spulen 24 erfolgt über die Zuleitungen 16. Das bisher als Spiegel 5 bezeichnete Element des Aktorteils 1 ist hier als optische Planparallelplatte 25 ausgebildet. Das Statorteil 2 hat hier die Öffnung 14 in der Unterseite, so daß ein freier Strahldurchgang, zum Beispiel bei Silizium im infraroten Spektralbereich, gewährleistet ist. Die optische Planparallelplatte 25 ist hier nur ein weiteres Beispiel für ein strahlbeeinflussendes optisches Element. Weiter sind Linsen, gekrümmte Spiegel, optische Gitter oder Fresnel-Strukturen als schwingender Spiegel 5 einsetzbar.

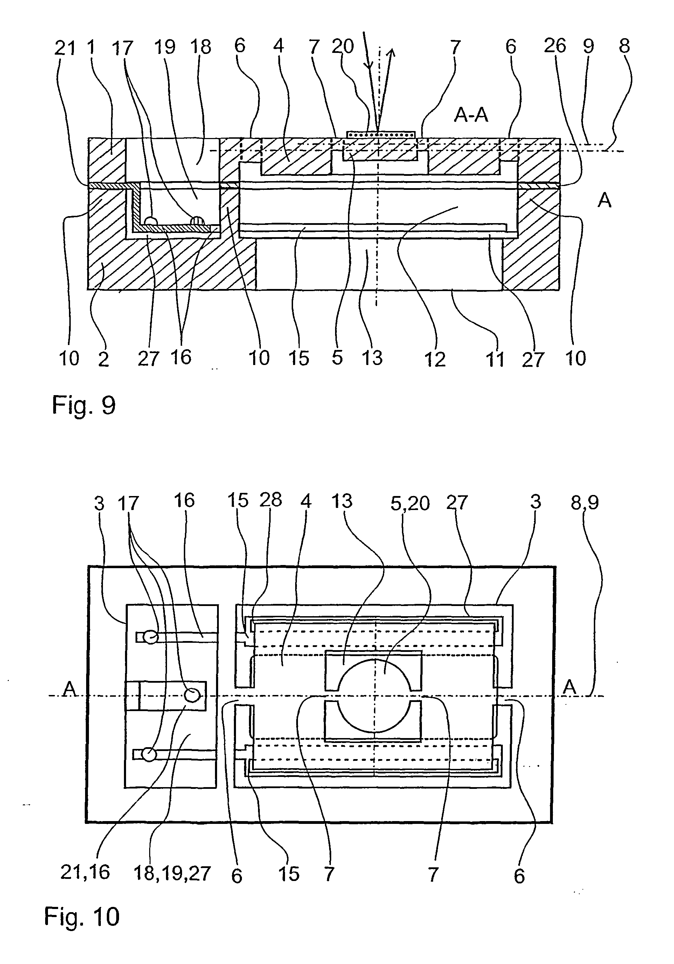

Fig. 9 zeigt eine Schnittdarstellung eines Resonatorscanners ähnlich der Fig. 1. Ein Unterschied besteht darin, daß hier das Statorteil 10 aus Glas gefertigt ist, weshalb die Schicht 27 eine Passivierungsschicht ist, die zur besseren Haftung der Statorelektroden 15 sowie der Zuleitungen 16 aufgebracht wurde. Ein weiterer Unterschied des in Fig. 9 dargestellten Resonatorscanners gegenüber dem in Fig. 1 gezeigten liegt darin, daß die Ausnehmung nun als Öffnung 13 ausgebildet ist, die sich auch über einen größeren Bereich erstreckt. Ansonsten entspricht der Resonanzscanner der Fig. 9 dem der Fig. 1.

Die Größe der Öffnung 13 ist in Fig. 10 gut zu erkennen, die ebenso wie Fig. 2 eine Draufsicht zeigt. Die Öffnung 13 ist, in einer Projektion auf die Ebene des Bodens 11 gesehen, quer zu den Torsionsachsen breiter als der Spiegel 5. In Richtung der Torsionsachsen erstreckt sich die Öffnung 13 über den auf den Boden 11 projizierten Rand der Antriebsplatte 4 hinweg.

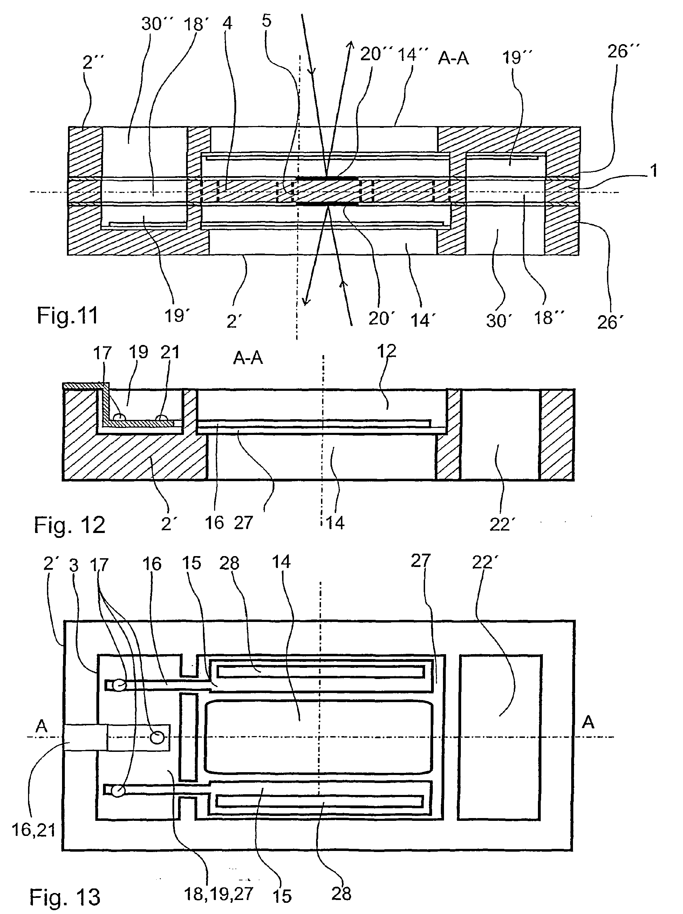

Fig. 11 zeigt eine Schnittdarstellung durch einen zweiseitig betätigten Resonanzscanner, der im wesentlichen dem in Fig. 3 dargestellten Resonanzscanner entspricht, mit dem Unterschied, daß die Öffnung 14' und 14", wie zuvor erwähnt, größer ausgeführt sind. Durch die größeren Öffnungen können Lichtstrahlen, die von den Spiegelflächen 20' bzw. 20" reflektiert werden, auch unter erheblich schrägerem Winkel einfallen, als bei der Bauweise der Fig. 3.

Fig. 12 zeigt eine Schnittdarstellung durch eines der Statorteile, hier das untere Statorteil 2' des Resonanzscanners der Fig. 11, und entspricht im wesentlichen der Darstellung der Fig. 6, wiederum mit dem Unterschied, daß die Öffnung 14 größer ausgeführt ist. Auch hier ist das Statorteil 2' aus Glas, weshalb die Isolationsschicht durch eine Haft- bzw. Passivierungsschicht 27 ersetzt ist.

Fig. 13 zeigt die zugehörige Draufsicht auf das Statorteil, wobei die vergrößerte Öffnung 14 gut zu erkennen ist. In zusätzlicher Abwandlung zu dem in Fig. 7 dargestellten Statorteil, weisen die Elektroden 15 Aussparungen 28 auf, die im vorliegenden Beispiel rechteckig sind. Die Aussparungen 28 sind in den Bereichen gebildet, in denen die Antriebsplatte 4 bei voller Auslenkung am Boden 11 anliegt. Durch die Aussparungen 28 ist sichergestellt, daß die Elektroden 15 auch dann, wenn die Antriebsplatte 4 voll ausgelenkt ist, nicht mit der Antriebsplatte 4 in Kontakt treten können. Die Abmessung der Aussparung 28 ist dabei so gewählt, daß immer ein ausreichender Abstand bzw. ein ausreichender Spalt zwischen Elektrode 15 und Antriebsplatte 4 gewährleistet ist, um einen Spannungsdurchschlag bzw. ein Anhaften der Antriebsplatte 4 an der Elektrode 15 unmöglich zu machen.

Nachfolgend soll beispielhaft ein Prozeß zur Herstellung des Aktorteils und des Statorteils sowie ihr Zusammenbau zu dem Resonatorspiegel beschrieben werden.

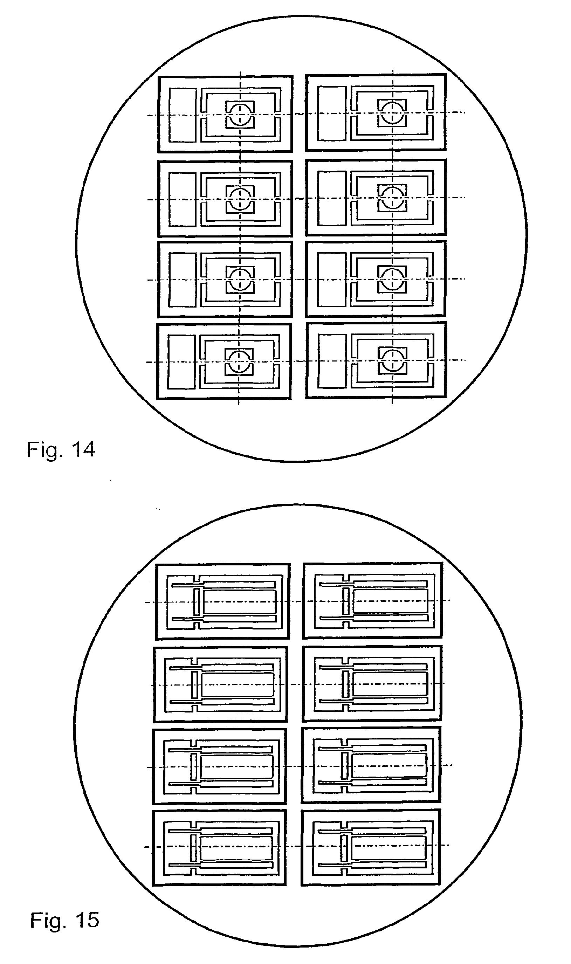

Ausgangsmaterial für die gleichzeitige Herstellung einer großen Zahl gleicher Aktorteile 1 ist ein doppelseitig polierter Siliziumwafer mit einer Dicke von 200 µm, der nachfolgend als Aktorwafer bezeichnet wird. Der Aktorwafer wird auf der Vorderseite mit einer ersten Aluminiumschicht und auf der Rückseite mit einer zweiten Aluminiumschicht beschichtet. Die Abscheidung erfolgt üblicherweise durch Magnetronsputtern. Mit Hilfe einer Lackschicht wird anschließend die Aluminiumschicht auf der Vorderseite des Aktorwafers strukturiert. Die Strukturierung erfolgt vorzugsweise durch Plasmaätzen. Die strukturierte Aluminiumschicht dient bei einen nun folgenden Trockenätzschritt als Maske. In diesem Schritt werden die Antriebsplatte 4, mit den ersten Torsionsfedern 6 sowie der Spiegel 5 mit den Torsionsfedern 7 herausgebildet. Das Ergebnis dieser Stufe des Herstellverfahrens ist in Fig. 14 dargestellt, die eine Draufsicht auf einen Aktorwafer zeigt. Der Rahmen 3, in dem die Torsionsfedern 6 mit der Antriebsplatte 4 hängen, gewährleisten dabei, daß die Eigenspannung des Materials, insbesondere im Bereich der Torsionsfedern 6 unverändert erhalten bleibt.

Danach wird die Aluminiumschicht durch ein naßchemisches Ätzverfahren entfernt, und die Spiegelschicht 20 wird auf die Vorderseite des Spiegels 5 abgeschieden. Das Material der Spiegelschicht 20 wird entsprechend der zu reflektierenden Wellenlänge gewählt. Üblicherweise ist das Material Aluminium oder ein Sandwich aus Chrom und Gold oder Silber mit entsprechenden Schutzschichten.

Ausgangsmaterial für die gleichzeitige Herstellung einer großen Zahl gleicher Statorteile 2, 2' und 2" ist ein doppelseitig polierter Siliziumwafer mit einer Dicke von 525 µm, der nachfolgend als Statorwafer bezeichnet wird. Der Statorwafer wird thermisch oxidiert und beidseitig mit einer Nitridschicht versehen. Die Oxidschichten und die Nitridschichten des Statorwafers werden mit Hilfe photolithographischer Prozesse und Plasmaätzschritten strukturiert.

Dabei werden das Layout der Ausnehmung 13 oder der Öffnung 14, der Freiraum 12, weiterhin die Grube 19 und die Bondöffnung 22 definiert hergestellt. Wird für den Statorwafer Glas verwendet, kann direkt eine Photolithographie mit Plasmaätzen eingesetzt werden.

Nach Entfernen aller Maskierungsschichten wird in die Grube 19 und auf die Grundfläche des Freiraumes 12 eine Isolatorschicht 27 aufgebracht. Dann wird darauf eine Metallisierungsschicht abgeschieden und so strukturiert, daß sich die Statorelektroden 15, Zuleitungen 16, Bondinseln 17 und der Polanschluß 21 bilden. Diesen Zustand zeigt Fig. 15 in einer Draufsicht auf den Statorwafer.

Im Fall des elektromagnetischen Antriebs werden die Spulen 24 mit dem Statorteil 2 innerhalb des Freiraumes 12 fixiert. Die Spule 24 wird zweckmäßigerweise als Flächenspule auf die Grundfläche des Freiraumes 12 aufgebracht, um eine geringe Bauhöhe zu realisieren. Die Spule 24 kann auch eine Spule 24 mit Drahtwindungen sein, die dann zweckmäßigerweise am Statorteil 2 fixiert wird und mit ihrem Polende in den Freiraum 12 hineinragt.

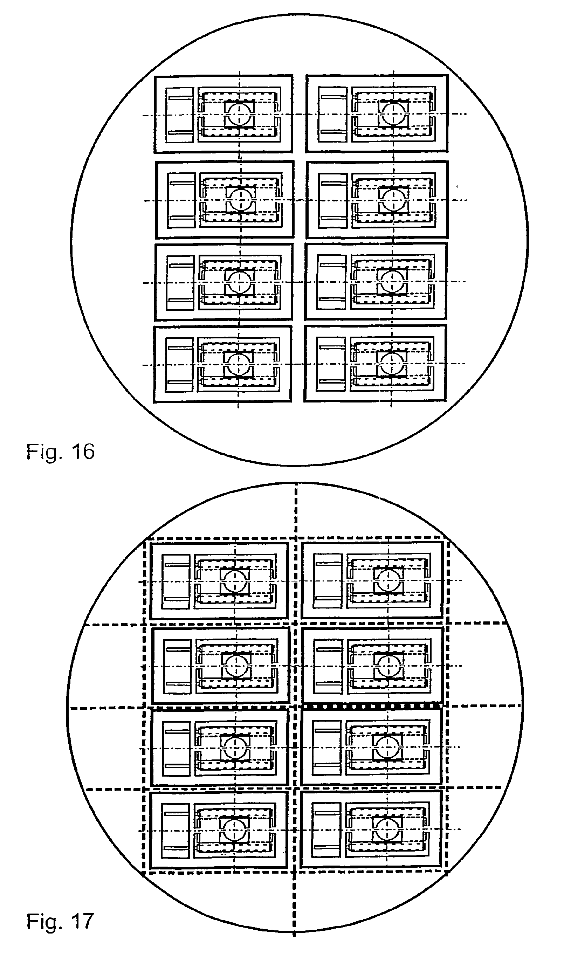

Der Aktorwafer 1 wird mit dem Statorwafer 2 oder 2' durch ein Niedertemperatur-Bondverfahren verbunden. Bei einem Glaswafer kann anodisch gebondet oder geklebt werden, bei Keramik ist Kleben möglich. Das Ergebnis ist in Fig. 16 als Draufsicht gezeigt.

Der entstandene Verbund wird dann im Fall des beidseitigen Antriebs mit dem weiteren, oberen Statorwafer 2" durch ein Niedertemperatur Bondverfahren verbunden. Das Vereinzeln des Verbundes erfolgt durch Trennsägen. Die Sägelinien sind in Fig. 15 gestrichelt eingetragen. Es liegen dann eine Vielzahl einsatzfähiger Resonatorspiegel vor.

## Patentansprüche

1. Resonanzscanner, bei dem
- ein Aktorteil (1) Befestigungselemente zum Verbinden mit einem Statorteil (2), eine Antriebsplatte (4), einen Spiegel (5) und Torsionsfedern (6, 7) aufweist, wobei
- die Antriebsplatte (4) an den Befestigungselementen über zwei erste Torsionsfedern (6) so befestigt ist, daß sie um eine gemeinsame erste Torsionsachse (8) der ersten Torsionsfedern (6) schwingungsfähig ist und eine erste Eigenfrequenz aufweist,
- der Spiegel (5) innerhalb und an der Antriebsplatte (4) durch zwei zweite Torsionsfedern (7) so befestigt ist, daß er um eine gemeinsame zweite Torsionsachse (9) der zweiten Torsionsfedern (7) schwingungsfähig ist und eine zweite Eigenfrequenz aufweist, die sich von der ersten Eigenfrequenz unterscheidet,
- die erste Torsionsachse (8) und die zweite Torsionsachse (9) parallel zueinander liegen und
- am Statorteil (2) ein Antriebsmittel (15, 24) im Bereich der Ausdehnung der Antriebsplatte (4) angeordnet ist, mittels dem Kraft unmittelbar auf die Antriebsplatte (4) ausübbar ist, wobei das Antriebsmittel (15, 24) derart ansteuerbar ist, daß die Kraft einer periodischen Funktion folgt, deren Periode auf die zweite Eigenfrequenz abgestimmt ist, wobei
- das Statorteil (2) kastenförmig mit umlaufenden Seitenwänden (10) und einem Boden (11) ausgebildet ist,
- die Befestigungselemente als Rahmen (3) ausgebildet sind, der an den Seitenwänden (10) des Statorteils (2) befestigt sind,
- die Antriebsmittel am Boden (11) des Statorteils (2) liegen und
- der Boden (11) im Bereich des Spiegels (5) eine Ausnehmung (13) hat, die die Dämpfung des Spiegels (5) reduziert und die mindestens so groß bemessen ist, daß eine maximale mechanische Auslenkung des Spiegels (5) nicht durch den Boden (11) begrenzt wird,
**dadurch gekennzeichnet, daß** die Ausnehmung (13) sich entlang den Torsionsachsen (8,9) mindestens so lang erstreckt, wie die Ausdehnung der darüberliegenden Antriebsplatte ist.

2. Resonanzscanner nach Anspruch 1, **dadurch gekennzeichnet, daß** das Antriebsmittel (15) elektrostatische und/oder elektromagnetische (24) Kräfte erzeugt, wobei auf dem Statorteil (2) fest angeordnete Komponenten des Antriebsmittels mit auf einer dem Boden (11) zugewandten Fläche der Antriebsplatte (4) angeordneten Komponenten des Antriebsmittels oder der Antriebsplatte (4) selbst zusammenwirken.

3. Resonanzscanner nach Anspruch 1 und Anspruch 2, **dadurch gekennzeichnet, daß** am Rahmen (3) des Aktorteils (1) auf beiden Seiten des Spiegels (5) gegenüberliegend jeweils ein Statorteil (2) befestigt ist.

4. Resonanzscanner nach Anspruch 1, **dadurch gekennzeichnet, daß** das Aktorteil (1) in einem Stück aus einem torsionsbeständigen Federmaterial hergestellt ist.

5. Resonanzscanner nach Anspruch 1 oder 4, **dadurch gekennzeichnet, daß** eine optische Wirkfläche des Spiegels (5) mit einer reflektierenden Schicht oder einer reflektierenden Schichtfolge beschichtet ist.

6. Resonanzscanner nach Anspruch 1, 4 oder 5, **dadurch gekennzeichnet, daß** sich zwei Wirkflächen des Spiegels (5) parallel gegenüberliegen, die jeweils eine Wellenlänge des elektromagnetischen Spektrums reflektieren, wobei eine Wirkfläche zur Reflexion eines Nutzstrahles und eine weitere Wirkfläche zur Reflexion eines Meßstrahles ausgelegt ist.

7. Resonanzscanner nach Anspruch 1, 5 oder 6, **dadurch gekennzeichnet, daß** der Spiegel (5) für eine Wellenlänge des elektromagnetischen Spektrums durchlässig ist.

8. Resonanzscanner nach Anspruch 1 oder nach einem oder mehreren der Ansprüche 5 bis 7, **gekennzeichnet durch** eine Wirkfläche des Spiegels (5), die optisch strahlformende Wirkung hat.

9. Resonanzscanner nach Anspruch 1 oder 3, **dadurch gekennzeichnet, daß** der Boden (11) des Statorteils (2) eine den Bereich des Spiegels (5) freilegende Öffnung (14) hat.

10. Resonanzscanner nach einem der obigen Ansprüche, **dadurch gekennzeichnet, daß** das Statorteil (2) einen Grundkörper aus einem elektrisch isolierenden Material, insbesondere Glas, Keramik oder Quarz, aufweist.

11. Resonanzscanner nach einem der obigen Ansprüche, **dadurch gekennzeichnet, daß** die Ausnehmung (13) größer ist als die Projektion des darüberliegenden Spiegels (5) auf die Ebene des Bodens (11).

12. Resonanzscanner nach einem der obigen Ansprüche, **dadurch gekennzeichnet, daß** die Antriebsmittel am Boden (11) liegende Elektroden (15) aufweisen, die so ausgebildet sind, daß auch bei voll ausgelenkter, am Boden (11) anliegender Antriebsplatte (4) zwischen Antriebsplatte (4) und Elektroden (15) ein Spalt besteht.

## Claims

1. A resonance scanner wherein
- an actuator part (1) comprises fixing elements for connection to a stator part (2), a drive plate (4), a mirror (5) and torsion springs (6, 7),
- said drive plate (4) is attached to the fixing elements via two first torsion springs (6) such that the drive plate (4) can oscillate about a common first axis of torsion (8) of the first torsion springs (6) and has a first eigenfrequency,
- said mirror (5) is attached within and to said drive plate (4) by two second torsion springs (7) such that said mirror (5) can oscillate about a common second axis of torsion (9) of the second torsion springs (7) and has a second eigenfrequency which is different from the first eigenfrequency,
- said first axis of torsion (8) and said second axis of torsion (9) are parallel to each other and
- a drive means (15, 24) is arranged on the stator part (2) in the region of the extent of the drive plate (4), said drive means (15, 24) allowing force to be applied directly to the drive plate (4) and being controllable such that said force follows a periodic function whose period is tuned to the second eigenfrequency,
- the stator part (2) having a box-shaped design with circumferential side walls (10) and a bottom (11),
- the fixing elements being provided as a frame (3) which is attached to the side walls (10) of the stator part (2),
- the drive means being arranged at the bottom (11) of the stator part (2), and
- the bottom (11) having a recess (13) in the region of the mirror (5), said recess (13) reducing damping of the mirror (5) and being dimensioned at least such that a maximum mechanical deflection of the mirror (5) is not limited by the bottom (11),
**characterised in that** the recess (13) extends along the axis of torsion (8, 9) over a length that is at least equal to the extent of the drive plate located above it.

2. The resonance scanner according to claim 1, **characterised in that** the drive means (15) generates electrostatic and/or electromagnetic (24) forces, with components of the drive means securely attached to the stator part (2) cooperating with components of the drive means or of the drive plate (4) itself, the latter components being arranged on a surface of the drive plate (4) facing the bottom (11).

3. The resonance scanner according to claim 1 and claim 2, **characterised in that** stator parts (2) are attached opposite each other, one on each side of the mirror (5), to the frame (3) of the actuator part (1).

4. The resonance scanner according to claim 1, **characterised in that** the actuator part (1) is integrally manufactured from a torsion-resistant resilient material.

5. The resonance scanner according to claim 1 or 4, **characterised in that** an optically active surface of the mirror (5) is coated with a reflecting layer or with a stack of reflecting layers.

6. The resonance scanner according to claim 1, 4 or 5, **characterised in that** two active surfaces of the mirror (5) are arranged opposite each other in parallel, each of said surfaces reflecting a wavelength of the electromagnetic spectrum, with one active surface being provided for reflection of a useful beam and a further active surface being provided for reflection of a measuring beam.

7. The resonance scanner according to claim 1, 5 or 6, **characterised in that** the mirror (5) is transparent for a wavelength of the electromagnetic spectrum.

8. The resonance scanner according to claim 1 or according to one or more of claims 5 to 7, **characterised by** an active surface of the mirror (5) having an optical beam-forming effect.

9. The resonance scanner according to claim 1 or 3, **characterised in that** the bottom (11) of the stator part (2) has an opening (14) exposing the region of the mirror (5).

10. The resonance scanner according to any one of the above claims, **characterised in that** the stator part (2) comprises a basic body of an electrically insulating material, in particular glass, ceramics or quartz.

11. The resonance scanner according to any one of the above claims, **characterised in that** the recess (13) is larger than the projection of the mirror (5) arranged above it onto the plane of the bottom (11).

12. The resonance scanner according to any one of the above claims, **characterised in that** the drive means comprise electrodes (15) arranged at the bottom (11), said electrodes (15) being provided such that there is a gap between the drive plate (4) and the electrodes (15) even when the drive plate (4) is fully deflected and arranged at the bottom (11).

## Revendications

1. Scanner à résonance, dans lequel
- une partie actionneur (1) présente des éléments de fixation pour la liaison avec une partie stator (2), une plaque d'entraînement (4), un miroir (5) et des ressorts de torsion (6, 7),
- la plaque d'entraînement (4) étant fixée de telle sorte sur les éléments de fixation au moyen de deux premiers ressorts de torsion (6), qu'elle fait vibrer autour d'un premier axe de torsion (8) commun des premiers ressorts de torsion (6) et présente une première fréquence propre,
- le miroir (5) est fixé de telle sorte à l'intérieur et sur la plaque d'entraînement (4) par deux seconds ressorts de torsion (7) qu'il peut vibrer autour d'un second axe de torsion (9) commun des seconds ressorts de torsion (7) et présente une seconde fréquence propre qui se différencie de la première fréquence propre,
- le premier axe de torsion (8) et le second axe de torsion (9) sont disposés en parallèle et
- sur la partie stator (2) est disposé un moyen d'entraînement (15, 24) dans la zone de l'extension de la plaque d'entraînement (4), au moyen duquel une force peut être exercée directement sur la plaque d'entraînement (4), le moyen d'entraînement (15, 24) pouvant être activé de telle sorte que la force suit une fonction périodique dont la période est assortie à la seconde fréquence propre,
- la partie stator (2) étant conçue en forme de caisse avec des parois latérales (10) périphériques et un fond (11),
- les éléments de fixation étant réalisés sous la forme de cadres (3) qui sont fixés sur les parois latérales (10) de la partie stator (2),
- les moyens d'entraînement sont disposés sur le fond (11) de la partie stator (2) et
- le fond (11) a dans la zone du miroir (5) un évidement (13) qui réduit l'amortissement du miroir (5) et qui est dimensionné au moins suffisamment grand pour qu'une déviation mécanique maximale du miroir (5) ne soit pas limitée par le fond (11),
**caractérisé en ce que** l'évidement (13) s'étend le long des axes de torsion (8, 9) au moins sur une longueur aussi grande que l'extension de la plaque d'entraînement disposée dessus.

2. Scanner à résonance selon la revendication 1, **caractérisé en ce que** le moyen d'entraînement (15) génère des forces électrostatiques et/ou électromagnétiques (24), des composants disposés de façon fixe sur la partie de stator (2) du moyen d'entraînement coopérant avec des composants du moyen d'entraînement ou de la plaque d'entraînement (4) qui sont disposés sur une surface, tournée vers le fond (11), de la plaque d'entraînement (4).

3. Scanner à résonance selon la revendication 1 et la revendication 2, **caractérisé en ce qu'**une partie stator (2) est fixée sur le cadre (3) de la partie actionneur (1) des deux côtés du miroir (5) en se faisant face.

4. Scanner à résonance selon la revendication 1, **caractérisé en ce que** la partie actionneur (1) est fabriquée d'une seule pièce dans un matériau de ressort résistant à la torsion.

5. Scanner à résonance selon la revendication 1 ou 4, **caractérisé en ce qu'**une face active optique du miroir (5) est revêtue avec une couche réfléchissante ou une séquence de couche réfléchissante.

6. Scanner à résonance selon la revendication 1, 4 ou 5, **caractérisé en ce que** deux faces actives du miroir (5) se font face parallèlement, qui réfléchissent chacune une longueur d'onde du spectre électromagnétique, une surface active étant conçue pour la réflexion d'un rayon utile et une autre face active pour la réflexion d'un rayon de mesure.

7. Scanner à résonance selon la revendication 1, 5 ou 6, **caractérisé en ce que** le miroir (5) est perméable pour une longueur d'onde du spectre électromagnétique.

8. Scanner à résonance selon la revendication 1 ou selon l'une quelconque ou plusieurs des revendications 5 à 7, **caractérisé par** une face active du miroir (5), qui a un effet de conformation de faisceau optique.

9. Scanner à résonance selon la revendication 1 ou 3, **caractérisé en ce que** le fond (11) de la partie stator (2) a une ouverture (14) qui dégage le fond du miroir (5).

10. Scanner à résonance selon l'une quelconque des revendications précédentes, **caractérisé en ce que** la partie stator (2) présente un corps de base à base d'un matériau électro-isolant, en particulier du verre, de la céramique ou du quartz.

11. Scanner à résonance selon l'une quelconque des revendications précédentes, **caractérisé en ce que** l'évidement (13) est plus grand que la projection du miroir (5) disposé au-dessus sur le plan du fond (11).

12. Scanner à résonance selon l'une quelconque des revendications précédentes, **caractérisé en ce que** les moyens d'entraînement présentent des électrodes (15) situées sur le fond (11), qui sont réalisées de telle sorte qu'une fente existe entre la plaque d'entraînement (4) et les électrodes (15) même lorsque la plaque d'entraînement (4) est complètement déviée et appliquée sur le fond (11).
